Europäisches Patentamt

European Patent Office

Office européen des brevets

(11) Publication number: **0 268 412**
**A1**

## (12) EUROPEAN PATENT APPLICATION

(21) Application number: **87309895.8**

(22) Date of filing: **09.11.87**

(51) Int. Cl.⁴ **H01R 4/04** , **H01R 9/07** , **H01R 23/68**

(30) Priority: **10.11.86 JP 171355/86**

(43) Date of publication of application:
**25.05.88 Bulletin 88/21**

(84) Designated Contracting States:
**BE CH DE FR GB IT LI NL SE**

(71) Applicant: **THOMAS & BETTS CORPORATION**
**920 Route 202**
**Raritan New Jersey 08869(US)**

(72) Inventor: **Yamada,Yoshio**
**Lainesuhaimu 1-609,1510**
**Shinyoshida-cho,Kouhoku-Ku**
**Yokohama-shi, Kanagawa-Pref.(JP)**
Inventor: **Nakamura,Mitsuru**
**2-24-2 Sakuradai, Isehara-shi**
**Kanagawa-Pref.(JP)**

(74) Representative: **Howick, Nicholas Keith et al**
**CARPMAELS & RANSFORD 43 Bloomsbury**
**Square**
**London WC1A 2RA(GB)**

(54) **Flexible jumper with anisotropically conductive adhesive.**

(57) A flexible jumper comprises a plurality of elongate conductors (1), provided in substantially parallel rows, each having a flat contact (1b) and a lead (1a) interconnected by a conductive main body. Flexible insulation surrounds the main bodies and lies beneath one surface of the contacts. An anisotropic adhesive (2) covers the upper non-insulated surface of the contacts, laterally thereacross.

FIG. I

## FLEXIBLE JUMPER WITH ANISOTROPICALLY CONDUCTIVE ADHESIVE

### FIELD OF THE INVENTION

The present device relates to a flexible jumper for connecting a printed circuit board to an LCD, an LED, and the like.

### BACKGROUND OF THE INVENTION

A typical jumper of this type is arranged such that a main body is constituted by a heat seal to provide flexibility, one end of the main body being bonded under pressure to an electrode of an LED display or the like, thereby assuring an electrical contact.

However, the conductive trace of the heat seal is obtained by coating a carbon powder using an adhesive and has a relatively high electrical resistance. Therefore, the allowable power range is narrow.

### SUMMARY OF THE INVENTION

It is an object of the present device to provide a jumper which solves the conventional problem and preserves conventional flexibility and high productivity.

A flexible jumper of the present device comprises a plurality of conductos, each having a lead at one end and a flat contact at the other end. The lead and the contact are connected by a conductive main body, the plurality of conductors being spaced apart from each other by a predetermined distance and being adapted to electrically connect electric components. An anisotropic adhesive resist layer covers the contacts of the plurality of conductors, and an insulating film substantially covers the plurality of conductors.

### BRIEF DESCRIPTION OF THE DRAWINGS

Fig. 1 is a perspective view showing an embodiment of the present jumper device.

Fig. 2 is a sectional view of the present device taken along the line A - A of Fig. 1.

Fig. 3 is a sectional view showing an application of the jumper device.

Fig. 4 is a perspective view showing another embodiment of the jumper device.

Fig. 5 is a sectional view of the embodiment taken along the line B - B of Fig. 4.

Fig. 6 is a perspective view showing a further application of the jumper device.

### DETAILED DESCRIPTION OF THE PREFERRED EMBODIMENTS

A flexible jumper according to the present application is described with reference to the embodiments illustrated in the drawing figures.

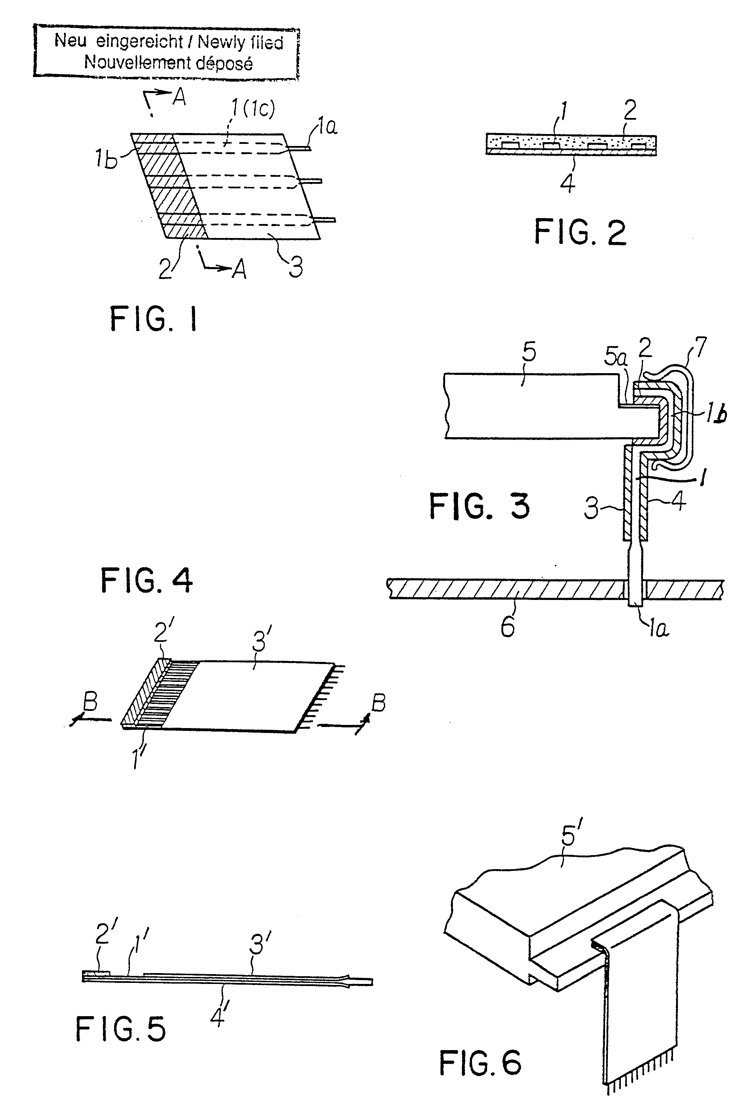

Fig. 1 shows a flexible jumper according to a first embodiment. Each conductor 1 has a lead 1a at one end thereof and a contact 1b at the other end thereof, and the contact and the lead are connected by a flat conductive main body 1c. The lead has an elongated post-like leg which can be easily inserted into a corresponding hole formed in, e.g., a printed circuit board. The contact is flat so that it can be bonded under pressure to an electrode of, e.g., a display panel.

An adhesive resist layer 2 covers the contacts of the conductors 1 and is a known anisotropically conductive film formed of carbon or metal fibers or particles that are dispersed. The carbon fibers or the like are aligned to extend parallel to each other to provide directivity to conductivity along the width of a thin film by using an adhesive as a binder. An insulating film 3 substantially covers the main bodies, and the leads are exposed.

Referring to Fig. 2, reference numeral 4 denotes an insulating film which covers the bottom of the entire jumper excluding the leads 1a.

Fig. 3 shows a state wherein the jumber shown in Fig. 1 is used to connect a display panel 5 and a printed circuit board 6. The adhesive resist layer 2 of the jumper is brought into contact with an electrode 5a of the display panel and is pressed by, e.g., a hot press from the outer side of the insulating film 4 with a contact 1b of the conductor facing inside, as shown in Fig. 3. The adhesive resist layer 2 is fixed by a clip 7, as shown in Fig. 3, if desired.

The adhesive resist layer 2 is deformed by pressure and heat to decrease the distance between the electrode 5a of the display and the contact 1b of the conductor of the jumper. At the same time, the electrode of the display is electrically connected to the contact of the jumper through the resist layer.

Fig. 4 shows another embodiment of a jumper according to the present device. A resist layer 2' is formed to partially cover the contacts of conductors 1'. Reference numeral 3' denotes a portion corresponding to the insulating film 3 show in Fig. 1.

Referring to Fig. 5, reference numeral 4' de-

notes a portion corresponding to the insulating film 4 shown in Fig. 2.

Fig. 6 shows a state wherein the jumber of the second embodiment is connected to a display panel. Reference numeral 5' denotes a portion coresponding to the display panel shown in Fig. 3.

Unlike in the conventional jumper which uses a heat seal, the jumper as the present device has the main bodies and the contacts, all of which are made of flat conductive members. Therefore, a higher power can be supplied, and the jumper of the present device can be connected to a plasma display requiring a larger current, in addition to an LED (light-emitting diode) and an LCD (liquid crystal display). Since the jumper itself is flexible, conventional operability and versatility are maintained.

Having described the preferred embodiments herein, it can be appreciated that other variations may be made without departing from the contemplated scope of the invention. Accordingly, the embodiments described herein are illustrative rather than limiting. The true scope of the invention is set forth in the claims appended hereto.

Claims

1. A flexible jumper comprising:
a plurality of conductors (1),(1'), each having a lead at one end an a flat contact at the other end, said lead and said contact being connected by a conductive main body, said plurality of conductos being spaced apart from each other by a predetermined distance and being adapted to electrically connect electric components;
an anisotropic adhesive resist layer (2),(2') covering said contacts of said plurality of conductors; and
a flexible insulating film (3),(3') substantially covering said conductive main bodies of said plurality of conductors.

2. A flexible jumper according to claim 1, wherein insulting film is formed to substantially cover both said contacts and said conductive main bodies of said plurality of conductors.

3. A flexible jumper according to claim 2, wherein said conductive main body connecting said lead and said contact of said each conductor is substantially flat.

4. A flexible jumper comprising:
a plurality of elongate conductors arranged in substantially parallel, laterally spaced rows, each conductor having a lead at one end and a flat contact at the other end, each said lead and contact being connected by a conductive main body;
a first, flexible insulative film disposed on one surface of said conductors, said first film covering at least said contacts and said conductive main bodies;
a second, flexible insulative film disposed on an opposite surface of said conductors, said second film covering at least said conductive main bodies and uncovering said contacts to thereby expose said contacts; and
an anisotropic adhesive resist layer extending laterally across said exposed contacts and being in adhered relation thereto, whereby said contacts are sandwiched between said layer and a portion of said first film.

5. A flexible jumper according to claim 4, wherein said leads are not covered by either said first or said film to thereby expose such leads for electrical connection to electric components.

6. A flexible jumper according to claim 4, wherein a longitudinal separation is provided between said layer and said second film.

Neu eingereicht / Newly filed
Nouvellement déposé

FIG. 1

FIG. 2

FIG. 3

FIG. 4

FIG. 5

FIG. 6

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | WO-A-8 606 551  (AMP)<br>* page 10, line 29 - page 11, line 8; figures 12-15 *<br>--- | 1-5 | H 01 R    4/04<br>H 01 R    9/07<br>H 01 R   23/68 |
| Y | US-A-2 073 962  (THOMAS & BETTS)<br>* page 1, lins 101-119; figures 1-4 *<br>--- | 1-5 | |
| A | EP-A-0 070 071  (N.V. PHILIPS' GLOEILAMPENFABRIEKEN)<br>* claims 1-3 *<br>--- | 1-3 | |
| A | EP-A-0 170 703  (NISSHA PRINTING CO.)<br>* page 4, lines 17-24; figures 1, 2 *<br>--- | 1,4 | |
| A | US-A-4 060 889  (E.J. ZIELINSKI)<br>* column 4, lines 16-21; figures 2-3 *<br>----- | 1-4 | |

TECHNICAL FIELDS SEARCHED (Int. Cl.4)

H 01 R    4/00
H 01 R    9/00
H 01 R   23/00

The present search report has been drawn up for all claims

| Place of search | Date of completion of the search | Examiner |
|---|---|---|
| BERLIN | 01-02-1988 | LEOUFFRE M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)